# EUROPEAN PATENT SPECIFICATION

(11) **EP 0 621 692 B1**
(45) Date of publication and mention of the grant of the patent: **02.09.1998**
(21) Application number: 94201029.9
(22) Date of filing: 15.04.1994
(51) Int. Cl.: H03K 19/003, H03K 19/0175

(54) **Overvoltage protection circuitry**
Überspannungsschutzschaltung
Circuit de protection contre les surtensions

(30) Priority: 19.04.1993 US 48973
(43) Date of publication of application: 26.10.1994
(73) Proprietor: Koninklijke Philips Electronics N.V., 5621 BA Eindhoven (NL)
(72) Inventor: Martin, Brian, NL-5656 AA Eindhoven (NL); Hanson, Harold, NL-5656 AA Eindhoven (NL); Anderson, Alma, NL-5656 AA Eindhoven (NL)
(74) Representative: de Haas, Laurens Johan

(56) References cited:
- US-A- 4 789 917
- US-A- 5 160 855

## Description

The invention relates to an electronic device comprising:
- a first circuit having a FET with a conduction channel between a supply node and an output node, and with a gate and a back gate;
- an overvoltage protection circuit coupled to at least the back gate for protecting the first circuit against overvoltages when the output node is coupled to a second circuit operating with a voltage that is higher than a voltage at the supply node.

Such a device is known from US patent application No.4,789,917. This circuit is intended specifically for the case that no power is supplied to the (positive) supply node. In this case the positive supply node will approach ground potential. Conventionally, the back gate is connected to the supply node. When a positive voltage is applied to the output node when the back gate of the transistor is fixed at a lower voltage this results in a forward biased p-n junction from output to supply voltage Vcc creating very large, undesirable, output-to-supply node currents.

To solve this problem the mentioned publication provides for a pair of FETs with conduction channels coupled between on one hand the back gate and on the other hand the supply node and the output node respectively. The gates of these FETs are cross-coupled to output node and the supply node respectively. Thus the voltage at the output node will be applied to the backgate when that voltage is higher than the voltage at the supply node.

Due to the increasing use of electronic circuitry operating with a supply voltage of 3 volts alongside of electronic circuitry operating with a 5 volts supply voltage, some parts of an electronic system may operate with 3-volt DC power sources, whereas other parts of the system may operate with 5-volt power sources. As an example, 3-volt IC's are needed which can interface with 5-volt busses. Standard complementary MOS (CMOS) and combined bipolar-CMOS (BiCMOS) outputs run into trouble in these applications due to the PMOS devices in their pull-up circuitry.

Three major problems are encountered with such parts when the bus to which they are connected is pulled towards 5 volts: (1) the drain of the PMOS is pulled towards 5 volts and with its back gate fixed at 3 volts (or Vcc < 5 volts) this results in a forward biased p-n junction from output to Vcc creating very large, undesirable, output-to-Vcc currents; (2) the PMOS device, with its gate held to 3 volts (or Vcc < 5 volts), cannot be turned off completely because the drain at the output has become the source, and the resulting gate-to-source voltage is greater than a threshold voltage drop, again resulting in large, undesirable output-to-Vcc currents; and (3) some systems allow multiple chips to pull the bus high simultaneously, meaning that the PMOS could possibly be turned on thereby creating, again, a very large positive output-to-Vcc current.

An object of the invention is overvoltage protection circuitry for IC circuits. Another object of the invention is a low-voltage operating circuit provided with protection circuitry for protecting the low-voltage circuit against overvoltages when connected to higher voltage circuits. A further object of the invention is CMOS or BiCMOS circuits adapted for operation at 3-volts but connected via pull-up circuitry to a 5-volt bus and provided with protection circuitry against overvoltages.

In accordance with one aspect of the invention the overvoltage protection circuit comprises a first Schottky diode having an anode connected to the supply node and having a cathode connected to the back gate;
- a second Schottky diode having an anode connected to the output and having a cathode connected to the cathode of the first diode and to the back gate. Thus the back gate follows the DC supply voltage for the circuit or the circuit output voltage, whichever is greater.

In accordance with another aspect of the invention, means are provided for providing complementary logic signals indicating when the output is pulled up above a certain value endangering the circuit to be protected. These logic signals can then be used to shut off via the FET's gate.

The various features of novelty which characterize the invention are pointed out with particularity in the claims annexed to and forming a part of this disclosure. For a better understanding of the invention, its operating advantages and specific objects attained by its use, reference should be had to the accompanying drawings and descriptive matter in which there are illustrated and described the preferred embodiments of the invention.

### SUMMARY OF DRAWINGS

In the drawings:
Fig. 1 shows a schematic of a simplified CMOS component of a standard CMOS and BiCMOS output stage;
Fig. 2 shows a schematic of the Fig. 1 circuit modified in accordance with the invention;
Fig. 3 shows a schematic of the overvoltage sensing part of one form of an overvoltage protection circuit to protect an output driver in accordance with the invention;
Fig. 4 shows a schematic of a circuit combining the sensing and driving parts of an overvoltage protection circuit in accordance with the invention.

### DETAILED DESCRIPTION OF PREFERRED EMBODIMENTS

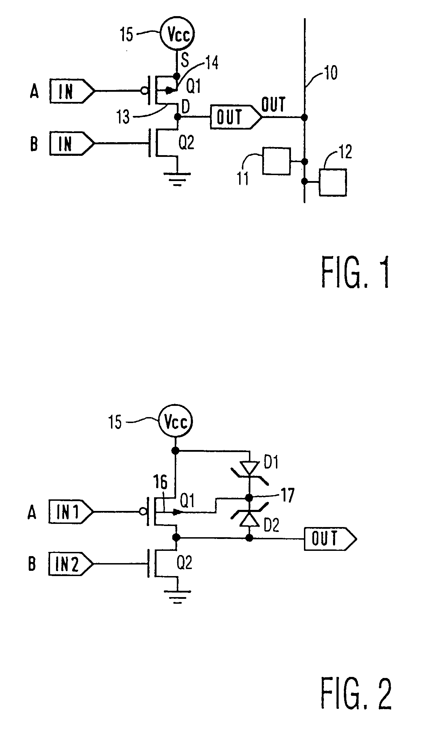

Figure 1 shows the simplified CMOS component of a standard CMOS and BiCMOS output stage, comprising serial-connected PMOS Q1 and NMOS Q2 transistors, with their common drain connected as an output OUT, to a bus 10 to which other bus interface circuits 11, 12 are also connected. Connected to the gates of Q1 and Q2, respectively, are input signal A and B.

NMOS and PMOS transistors are represented conventionally, the PMOS has the circle at its gate. Vcc is the logic-high level, and Gnd the logic-low signal. Crossing conductors do not make connections at their crossings, except where they pass through a MOS gate or bipolar base.

If the bus 10 were driven to 5 volts and the output were in tri-state (A at Vcc or higher and B at Gnd), then Q1 would have its p-type drain 13 at 5 volts and its n-type back gate 14 tied to its source at Vcc. For a part with a supply voltage Vcc of 3 volts, this would result in a forward-biased p-n junction from the output to Vcc via the back gate 14.

A solution to this problem in accordance with the invention is shown in Figure 2. Schottky diodes D1, between Vcc and node 17, and D2, between output OUT and node 17, keep the back gate 16 of Q1 from ever being more than a Schottky drop below its source and drain. However, if the gate of Q1 is driven by A of about 3 volts, there would still be more than a threshold voltage between the gate and the output, resulting in a well-conducting channel from the 5-volt output to Vcc supply 15. Input signal A would have to pull the gate of Q1 well within a MOS threshold of the output in order to completely shut it off. Furthermore, some systems allow multiple chips (see 11, 12 in Fig. 1) to pull the bus 10 high at once. If Q1 were to be pulling the output to its 3-volt Vcc at the same time as another chip on the bus were pulling it to 5 volts, a "high contention" state would arise in which very large currents would pass from the output through Q1 into Vcc.

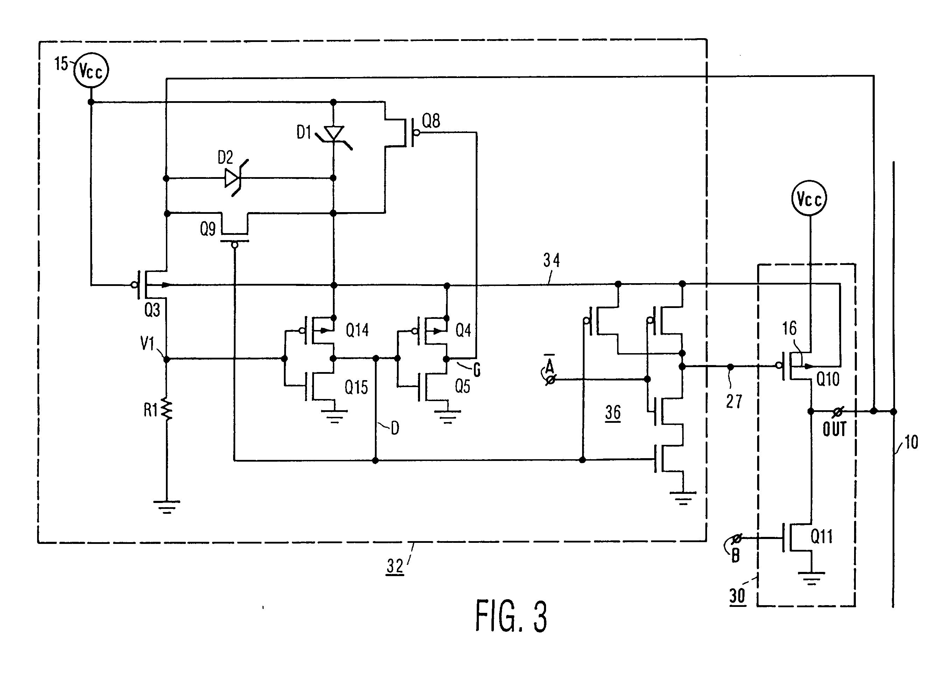

Fig. 3 shows output driver 30 being controlled by an overvoltage protection circuit 32 in accordance with the invention to provide a solution to these problems so that low voltage, e.g., 3-volt, CMOS and BiCMOS outputs can interface to a higher voltage, e.g., 5-volt, bus. Schottky diodes D1 and D2 provide at their junction an accessible voltage node 34, which can be used to protect the back gate of pull-up PMOS device Q10 connected to an output OUT. Furthermore, logic signals C and D are generated that are complementary signals indicating when output OUT has been pulled approximately a MOS threshold above local supply voltage Vcc of node 15. As long as output OUT remains at Vcc or lower, PMOS Q3 remains entirely off, and node V1 is held at Gnd through a resistance R, meaning that via inverters Q14/Q15 and Q4/Q5 signal D is held to Vcc and signal C to Gnd. As the voltage at output OUT increases and approaches a MOS threshold above Vcc, Q3 begins to conduct from output OUT into node V1, switching D low and C high, thus indicating an "overvoltage condition". These signals can be used to logically shut off Q10 in output driver 30 in the case of a high contention, the state when pull-up PMOS device Q10 is pulling its output up to 3-volt when another circuit connected to the same node is trying to pull its output up to 5-volt when driver 30 has its output OUT connected to bus 10.

To this end, sensing circuit 32 has a logic gate 36, e.g., a NAND gate, for control of PMOS Q10 via PMOS control gate 27 gate in response to both input signal A(BAR) and control signal D, so that when D goes low, indicating high contention, Q10 will shut off. Note that the connection to node 34 of the back gate of the PMOS transistor Q10 and of the PMOS transistors in logic gate 36 protects these transistors against back gate conduction.

Since the source of Q4 is tied to node 36 instead of to Vcc, when signal C pulls high, it pulls all the way within a Schottky drop of output OUT. The same technique can be used to shut off Q10. When signal B goes low and signal A goes high to place output OUT in tri-state, signal D pulls up to within a Schottky voltage drop of whichever is at higher potential, output OUT or Vcc, ensuring that Q10 is shut off.

A shortcoming could be that diode D2 tends to capacitively couple node 34 with output OUT. Thus, if output OUT makes a 3-volt to Gnd transition, node 34 tends to dip somewhat in voltage. That causes the gate of Q10, which is already a Schottky drop below Vcc in tri-state, to dip somewhat as well, allowing significant leakage through Q10. Preferably, to avoid this problem, small PMOS devices Q8 and Q9 are placed in parallel with the diodes D1 and D2 being controlled by signals C and D, respectively. In the case of normal operation, signal C is low and Q8 provides a path to pull node 34 all the way up to Vcc. In the overvoltage condition, signal C goes high (turning off Q8) and signal D goes low turning on Q9, which gradually pulls node 34 all the way up to the output voltage.

Instead of directly connecting the gate of transistor Q3 to Vcc, the voltage at the gate of Q3 could be set a Schottky diode drop down from Vcc, using a voltage divider of an additional diode and an additional resistor (not shown) so the signal at output OUT does not have to go so high for Q3 to turn on. This circuit, however, will consume more static power through the additional diode and the additional resistor.

Overvoltage protection sensing circuitry 32 of Figure 3 provides the voltage node and logic signals necessary to enable 3-volt CMOS and BiCMOS ICs to interface with a 5-volt bus. While the latter voltages are the ones most in used today, it will be appreciated that the invention is not limited to those particular values or to the systems illustrated, i.e., not necessarily to a bus environment, but is usable in and applicable to other systems or environments where lower voltage circuits have to interface to higher voltage circuits, or in general to circuits with different power supplies driving a common node.

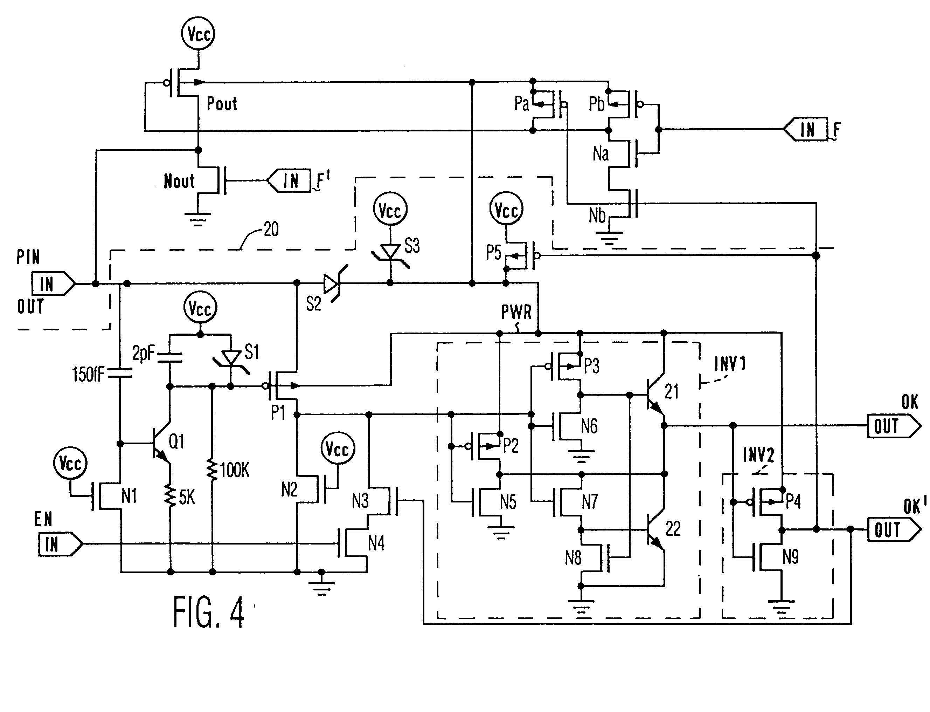

Fig. 4 is an example in accordance with the invention which combines both the sensing and driving parts in a 3-volt bidirectional transceiver interface circuit of the BiCMOS type for interfacing to a 5-volt bus. In the example shown, F at the right side represents an input signal, EN at the left side an enable signal, and OK and OK' correspond to signals C and D in Fig. 3. The significant parts in the Fig. 4 circuit relevant to the invention and corresponding to parts in the Fig. 6 circuit are shown in the Table below:

**TABLE**

| Fig. 7 Part | corresponds to | Fig.3 Part |
|---|---|---|
| P1 | | Q3 |
| N2 | | R |
| P2/N5 | | Q4/Q5 |
| S3 | | D1 |
| S2 | | D2 |

The part below the dashed line 20 is the sensing part, and the part above the driver part.

In operation, Pout is the PMOS driver for the PIN OUT output. Pa, Pb, Na, and Nb function as a 2-input NAND gate. Assume input F is low. Pb would be on, turning Pout off. F'(or FBAR) would be high, so Nout would pull the output OUT low. With OUT low below Vcc, the logic signals OK is high and OK' is low. Now assume F goes high. Pb turns off, Na turns on turning on Pout, which would pull the output OUT high. The OUT PIN is typically connected to a bus. If another part on the bus with a 5-volt Vcc pulls the output over the 3-volt Vcc of this circuit, OK would go low, and Pa would turn Pout off preventing damage to the circuit.

In the sensing part below the dashed line, N1 and N2 with Vcc on the gate act as resistors. The circuit designated INV1 functions as a standard BiCMOS inverter; the circuit designated INV2 functions as a standard MOS inverter.

While the invention has been described in connection with preferred embodiments, it will be understood that modifications thereof within the principles outlined above will be evident to those skilled in the art.

## Claims

1. An electronic device comprising:
- a first circuit having a FET (Q1; Q10) with a conduction channel between a supply node and an output node, and with a gate and a back gate;
- an overvoltage protection circuit coupled to at least the back gate for protecting the first circuit against overvoltages when the output node is coupled to a second circuit operating with a voltage that is higher than a voltage at the supply node (15, Vcc),
characterized in that the overvoltage protection circuit (D1/D2; 32) comprises a first Schottky diode (D1) having an anode connected to the supply node and having a cathode connected to the back gate;
- a second Schottky diode (D2) having an anode connected to the output and having a cathode connected to the cathode of the first diode and to the back gate, the first and second Schottky diodes (D1, D2) making the back gate follow the higher of the output node or the supply node voltage.

2. The device of Claim 1, wherein the overvoltage protection circuit further comprises:
- control means (Q3/R1, Q14/Q15, Q4/Q5, 36) for providing a control signal to the gate of the FET (Q10) to control the same upon detection of the voltage at the output node being higher than the supply node voltage.

3. The device of Claim 2, the backgate being coupled to a voltage node (17; 34) wherein the control means comprise:
- a voltage divider comprising a conduction channel of a further FET (Q3) arranged between the output and a further node (V1), the further FET having a gate connected to the supply node and a back gate connected to the voltage node (34);
- a logic gate means (Q14/Q15, Q4/Q5, 36) having a first input connected to the further node (V1), a second input for receipt of a control signal for governing a logic state at the gate of the FET (Q10), a gate supply node connected to the voltage node for power supply of the logic gate means, and having an output for under combined control of the voltage at the further node and the voltage at the second input governing the state of the FET (Q10).

4. The device of Claim 3, wherein the overvoltage protection circuit comprises first and second by-pass FETs (Q8 and Q9) arranged in parallel with the first and second Schottky diodes, respectively, for being complementarily controlled by the logic gate means.

## Patentansprüche

1. Elektronische Anordnung mit:
- einer ersten Schaltungsanordnung mit einem Feldeffekttransistor (Q1; Q10) mit einem Leitungskanal zwischen einem Speiseknotenpunkt und einem Ausgangsknotenpunkt, und mit einer Gate-Elektrode und einem Substrat;
- einer Überspannungsschutzschaltung, gekoppelt mit wenigstens dem Substrat zum Schützen der ersten Schaltungsanordnung gegen Überspannung, wenn der Ausgangsknotenpunkt mit einer zweiten Schaltungsanordnung gekoppelt ist, die mit einer Spannung arbeitet, die höher ist als eine Spannung an dem Speiseknotenpunkt (15, Vcc),
dadurch gekennzeichnet, daß die Überspannungsschutzschaltung (D1/D2; 32) eine erste Schottky-Diode (D1), deren Anode mit dem Speiseknotenpunkt und deren Kathode mit dem Substrat verbunden ist;
- eine zweite Schottky-Diode (D2) aufweist, deren Anode mit dem Ausgang und deren Kathode mit der Kathode der ersten Diode und mit dem Substrat verbunden ist, wobei die erste und zweite Schottky-Dioden (D1, D2) dafür sorgen, daß das Substrat dem höheren der beiden Knotenpunkte, d. h. Ausgangsknotenpunkt oder Speiseknotenpunkt, folgt.

2. Schaltungsanordnung nach Anspruch 1, wobei die Überspannungsschutzschaltung weiterhin die nachfolgenden Elemente aufweist:
- Steuermittel (Q3/R1, Q14/Q15, Q4/Q5, 36) zum Liefern eines Steuersignals zu der ersten Schaltungsanordnung zur Steuerung derselben bei Detektion der Spannung an dem Ausgangsknotenpunkt, der höher ist als die Spannung des Speiseknotenpunktes.

3. Schaltungsanordnung nach Anspruch 2, wobei das Substrat mit einem Spannungsknotenpunkt (17; 34) gekoppelt ist, wobei die Steuermittel die nachfolgenden Elemente aufweisen:
- einen Spannungsteiler mit einem leitenden Kanal eines weiteren FETs (Q3) zwischen dem Ausgang und einem weiteren Knotenpunkt (V1), wobei von dem weiteren FET eine Gate-Elektrode mit dem Speiseknotenpunkt verbunden ist und das Substrat mit einem Spannungsknotenpunkt (34) verbunden ist;
- ein logisches Gatter (Q14/Q15, Q4/Q5, 36), von dem ein erster Eingang mit dem weiteren Knotenpunkt (V1) verbunden ist, ein zweiter Eingang für den Empfang eines Steuersignals dient zur Regelung eines logischen Zustandes an der Gate-Elektrode des FETs (Q10), wobei ein Gate-Elektrodenspeiseknotenpunkt nit dem Spannungsknotenpunkt verbunden ist zur Speisung der logischen Gatter und wobei ein Ausgang vorgesehen ist zur, unter kombinierter Steuerung der Spannung an dem weiteren Knotenpunkt und der Spannung an dem zweiten Eingang, Regelung des Zustandes des FETs (Q10).

4. Schaltungsanordnung nach Anspruch 3, wobei die Überspannungsschutzschaltung einen ersten und einen zweiten Umleitungs-FET (Q8 und Q9) aufweist, parallel zu der ersten bzw. zweiten Schottky-Diode zur komplementären Steuerung durch das logische Gatter.

## Revendications

1. Dispositif électronique comportant: - un premier circuit comprenant un transistor à effet de champ (Q1; Q10) muni d'un canal de conduction disposé entre un noeud d'alimentation et un noeud de sortie, et d'une porte et d'une porte arrière;
- un circuit de protection contre les surtensions couplé à au moins la porte arrière afin de protéger le premier circuit contre les surtensions se produisant dans le cas où le noeud de sortie est couplé à un deuxième circuit fonctionnant avec une tension qui est plus élevée qu'une tension se produisant au noeud d'alimentation (15, Vcc), caractérisé en ce que le circuit de protection contre les surtensions (D1/D2; 32) comprend une première diode Schottky (D1) dont une anode est connectée au noeud d'alimentation et dont une cathode est connectée à la porte arrière;
- une deuxième diode Schottky (D2) dont une anode est connectée à la sortie et dont une cathode est connectée à la cathode de la première diode et à la porte arrière, les première et deuxième diodes Schottky (D1, D2) assurant que la porte arrière suit la plus élevée de la tension du noeud de sortie ou du noeud d'alimentation.

2. Dispositif selon la revendication 1, dans lequel le circuit de protection contre les surtensions comprend davantage:
- des moyens de contrôle (Q3/R1, Q14/Q15, Q4/Q5, 36) pour fournir un signal de contrôle à la porte du transistor à effet de champ afin de contrôler ce dernier pendant la détection lorsque la tension se produisant au noeud de sortie est plus élevée que la tension présente au noeud d'alimentation.

3. Dispositif selon la revendication 2, dans lequel la porte arrière est couplée à un noeud de tension (17, 34) et dans lequel les moyens de contrôle comprennent:
- un diviseur de tension comprenant un canal de conduction d'un autre transistor à effet de champ (Q3) disposé entre la sortie et un autre noeud (V1), l'autre transistor à effet de champ étant muni d'une porte connectée au noeud d'alimentation et d'une porte arrière connectée au noeud de tension (34);
- des moyens de porte logiques (Q14/Q15, Q4/Q5, 36) comportant une première entrée connectée à l'autre noeud (V1), une deuxième entrée pour la réception d'un signal de contrôle pour déterminer un état logique à la porte du transistor à effet de champ (Q10), un noeud d'alimentation de porte connecté au noeud de tension pour l'alimentation de puissance des moyens de porte logiques, et comportant une sortie pour déterminer l'état du transistor à effet de champ (Q10) sous contrôle combiné de la tension se produisant à l'autre noeud et la tension se produisant à la deuxième entrée.

4. Dispositif selon la revendication 3, dans lequel le circuit de protection contre les surtensions comprend des premier et deuxième transistors à effet de champ de dérivation (Q8, Q9) montés en parallèle respectivement par rapport aux première et deuxième diodes Schottky pour un contrôle complémentaire par les moyens de porte logiques.
